# EUROPEAN PATENT SPECIFICATION

(11) **EP 2 341 545 B1**
(45) Date of publication and mention of the grant of the patent: **02.07.2014**
(21) Application number: 09821964.5
(22) Date of filing: 15.10.2009
(51) Int. Cl.: H01L 29/739, H01L 21/336, H01L 29/12, H01L 29/78, H01L 21/331, H01L 29/08, H01L 29/10, H01L 29/66

(54) **IGBT MANUFACTURING METHOD**
VERFAHREN ZUR HERSTELLUNG EINES IGBTS
PROCEDE DE FABRICATION D'UN IGBT

(30) Priority: 24.10.2008 JP 2008273780
(43) Date of publication of application: 06.07.2011
(73) Proprietor: TOYOTA JIDOSHA KABUSHIKI KAISHA, Toyota-shi, Aichi-ken, 471-8571 (JP)
(72) Inventor: NISHIWAKI Tsuyoshi, Toyota-shi Aichi 471-8571 (JP); SAITO Jun, Toyota-shi Aichi 471-8571 (JP)
(74) Representative: TBK
(86) International application number: PCT/JP2009/067844
(87) International publication number: WO 2010/047267

(56) References cited:
- EP-A1- 1 536 463
- JP-A- 11 251 573
- JP-A- 2005 210 047
- JP-A- 2007 266 134
- JP-A- 2008 205 205
- JP-A- 2008 205 205
- US-A1- 2008 079 081

## Description

A technique disclosed in this specification relates to a method for manufacturing an IGBT.

In Japanese Published Patent Application No. H11-251573, an IGBT including an n-type floating region formed within a p-type body region is disclosed. The floating region is a region divided from an emitter region and a drift region. The floating region formed within the body region suppresses flow of carriers from the drift region to the body region when the IGBT is on. Consequently, a state in which many carriers exist in the drift region is caused and an electric resistance of the drift region is decreased. Therefore, an on-voltage of the IGBT can be decreased.

Prior art which is related to this field of technology can be found e.g. in document US 2008/079081 A1 disclosing a semiconductor apparatus and manufacturing method, document JP 2008 205205 A disclosing a semiconductor device, and manufacturing method thereof, and document EP 1 536 463 A1 disclosing a method for manufacturing a power device with insulated trench-gate having controlled channel length and corresponding device.

When the IGBTs are manufactured, because n-type and p-type impurity regions are formed by injecting impurities to semiconductor substrates, a variation of the density of the impurities in the semiconductor substrates is caused in products. In the IGBTs including the floating region, widths of the floating regions (the widths along a depth direction) vary because of the variation of the density of the impurities in the floating regions in the products. If the widths of the floating regions vary, lengths of channels of the IGBTs vary. Consequently, a problem that the on-voltages of the IGBTs vary greatly is caused.

A technique disclosed in this specification is created based on facts described above. This specification provides a method for manufacturing an IGBT including a configuration which can suppress the variation of on-voltages even if a production variation of the density of the impurities is caused.

An IGBT disclosed in this specification is a vertical IGBT. The IGBT includes an emitter region, a body region, a drift region, a collector region, a floating region, and a gate electrode. The emitter region is a region of a first conductive type. The body region is a region of a second conductive type being adjacent to the emitter region at a deeper side of the emitter region. The drift region is a region of the first conductive type being adjacent to the body region at a deeper side of the body region and being divided from the emitter region by the body region. The collector region is a region of the second conductive type being adjacent to the drift region at a deeper side of the drift region and being divided from the body region by the drift region. The floating region is a region of the first conductive type being formed within the body region and being divided from both of the emitter region and the drift region by the body region. The gate electrode faces a range of the body region via an insulating film, and the range is dividing the emitter region from the drift region. A density of first conductive type impurities at a boundary of the floating region and the body region that is above the floating region is distributed to increase from an upper side to a lower side. A density of the first conductive type impurities at a boundary of the floating region and the body region that is under the floating region is distributed to decrease from an upper side to a lower side. A density of second conductive type impurities at a boundary of the floating region and the body region that is above the floating region is distributed to decrease from an upper side to a lower side. A density of the second conductive type impurities at a boundary of the floating region and the body region that is under the floating region is distributed to increase from an upper side to a lower side.

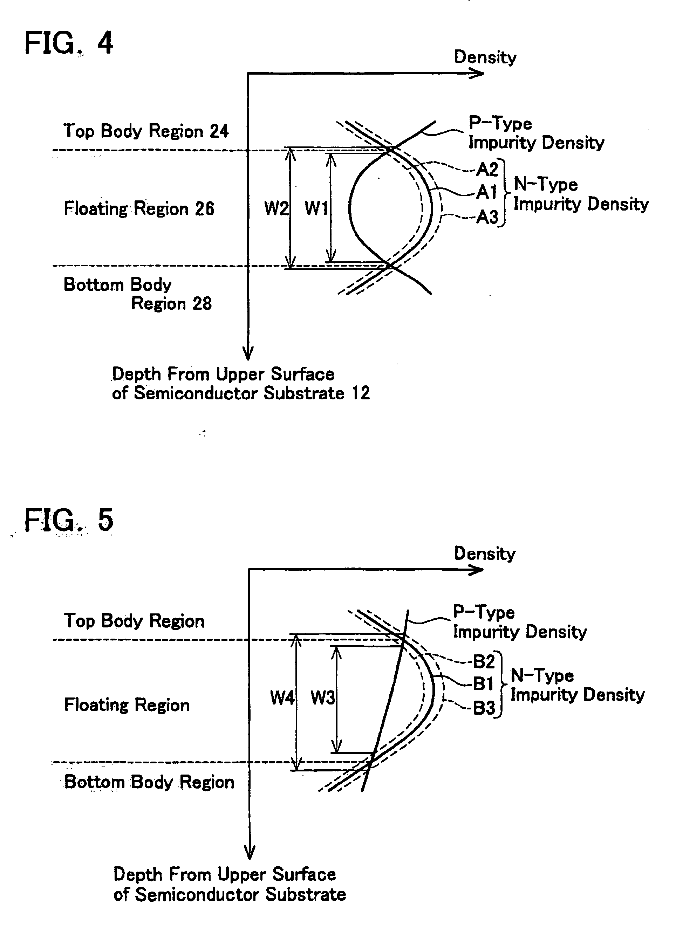

Fig.4 shows a distribution of densities of the n-type impurities and the p-type impurities near the floating region of an IGBT illustrated as an example of the technique disclosed in this specification. Note that in Fig.4, a graph A1 traced by a solid line shows the density of the n-type impurities of a designed value of the IGBT and graphs A2 and A3 traced by dot lines show densities of the n-type impurities when predetermined variation from the designed value is caused. As shown in Fig.4, in the IGBT, near the boundary of the body region that is above the floating region (hereinafter may be referred to as a top body region) and the floating region, the density of the n-type impurities increases from an upper side (a top body region side) to a lower side (a floating region side) and the density of the p-type impurities decreases from the upper side to the lower side. On the other hand, near the boundary of the body region that is under the floating region (hereinafter may be referred to as a bottom body region) and the floating region, the density of the n-type impurities decreases from the upper side (a floating region side) to the lower side (a bottom body region side) and the density of the p-type impurities increases from the upper side to the lower side. In the IGBT shown in Fig.4 as the example, if the variation of the densities of the n-type impurities is caused as shown in the graphs A2 and A3, the width of the floating region varies between a width W1 and a width W2. Also, Fig.5 shows a distribution of densities of the n-type impurities and the p-type impurities near the floating region of a conventional IGBT. Note that in Fig.5, a graph B1 traced by the solid line shows the density of the n-type impurities of a designed value of the conventional IGBT and graphs B2 and B3 traced by the dot lines show the densities of the n-type impurities when a predetermined variation from the designed value is caused. In the conventional IGBT shown in Fig.5, the density of the p-type impurities is distributed to decrease smoothly from the top body region to the bottom body region. The reason why the density of the p-type impurities is distributed in this manner is that when manufacturing the conventional IGBT, the p-type impurities are first injected to an entire range corresponding to the body region and the floating region, and then, the n-type impurities are injected to a range corresponding to the floating region at a high density (at a higher density than the density of the p-type impurities). As shown in Fig.5, in the conventional IGBT, if the variation of the densities of the n-type impurities is caused as shown in the graphs B2 and B3 (these variations are same amounts as those in the graphs A2 and A3 in Fig.4), the width of the floating region vary between a width W3 and a width W4. Because the densities of the impurities at the boundaries of the floating region are distributed as described above in the IGBTs provided by the technique disclosed in this specification, it is clear by comparing Fig.4 and Fig.5 that the variation of the widths of the floating regions (i.e. a difference of the widths W1 and W2) becomes smaller than the variation of the widths of the floating regions among the conventional IGBTs (i.e. a difference of the widths W3 and W4). That is, even if the densities of the n-type impurities vary, the widths of the floating regions of the IGBTs provided by the technique disclosed in this specification are more unlikely to vary than the conventional IGBTs. Therefore, among the IGBTs provided by the technique disclosed in this specification, the on-voltages are unlikely to vary. Note that the above description describes the case where variation of the densities of the n-type impurities is caused, but the same may apply when the variation of the densities of the p-type impurities is caused because the width of the floating region depends on the distributions of both of the densities of the n-type impurities and the p-type impurities. In a case where the variation of the densities of the p-type impurities is caused, among the IGBTs provided by the technique disclosed in this specification, the widths of the floating regions are unlikely to vary and the on-voltages are more unlikely to vary than the conventional IGBTs. Note that the IGBT shown in Fig.4 is merely an example of the IGBT provided by the technique disclosed in this specification. The IGBT having a distribution other than the distribution shown in Fig.4 is also included in the technique disclosed in this specification, if the densities of the impurities are distributed as described above. Furthermore, although the floating region is the n-type, and the top body region and the bottom body region are the p-type in Fig.4, the same effect is obtained even if the floating region is the p-type, and the top body region and the bottom body region are the n-type.

In the IGBT described above and provided by the technique disclosed in this specification, a density of the second conductive type impurities in the body region that is above the floating region may preferably be distributed to have a local maximum value in a vertical direction. The local maximum value may be a maximum value of the density of the second conductive type impurities in the body region that is above the floating region. The maximum value of the density of the second conductive type impurities in the top body region greatly affects a gate threshold voltage. If the production variation of these maximum values is large, the gate threshold voltages of the IGBTs vary greatly. If the maximum value of the density of the second conductive type impurities in the top body region is at the boundary between the top body region and the emitter region or at the boundary between the top body region and the floating region, that maximum value varies greatly by being affected by the variations of both of the first conductive type impurities and the second conductive type impurities. For example, even if the density of the second conductive type impurities is fixed, if the distribution of the density of the first conductive type impurities varies, the position of the boundary between the emitter region and the top body region varies and the maximum value of the density of the second conductive type impurities also varies. On the other hand, if the local maximum value of the density of the second conductive type impurities in the top body region is the maximum value of the density of the second conductive type impurities in the top body region, that maximum value is not affected by the variation of the density of the first conductive type impurities. Therefore, the variation of the maximum values of the densities of the second conductive type impurities in the top body regions is suppressed. Consequently, the variation of the gate threshold voltages is suppressed among the IGBTs.

In the IGBT described above and provided by the technique disclosed in this specification, a density of the second conductive type impurities in the body region that is under the floating region may preferably be distributed to have a local maximum value in a vertical direction. The local maximum value of the density of the second conductive type impurities in the body region that is under the floating region may be a maximum value of the density of the second conductive type impurities in the body region under the floating region. The maximum value of the density of the second conductive type impurities in the bottom body region also greatly affects the gate threshold voltage of the IGBT. If the local maximum value of the density of the second conductive type impurities in the bottom body region is the maximum value of the density of the second conductive type impurities in the bottom body region, this maximum value is not affected by the variation of the density of the first conductive type impurities. Therefore, the variation of the maximum values of the densities of the second conductive type impurities in the bottom body regions is suppressed. Consequently, the variation of the gate threshold voltages is suppressed among the IGBTs.

In the IGBT described above and provided by the technique disclosed in this specification, a maximum value of a density of the second conductive type impurities in the body region that is above the floating region may preferably be larger than a maximum value of a density of the second conductive type impurities in the body region that is under the floating region. The gate threshold voltage of the IGBT is affected most greatly by higher one of the maximum value of the density of the second conductive type impurities in the top body region and the maximum value of the density of the second conductive type impurities in the bottom body region. If the maximum values are configured as described above, the gate threshold voltage is decided based on the maximum value of the density of the second conductive type impurities of the top body region, and the variation of the gate threshold voltages is suppressed. Furthermore, it is not necessary to inject more impurities to a deep area of the semiconductor substrate than the configuration having the high maximum value of the density of the second conductive type impurities in the bottom body region. Therefore, it is suppressed that the crystal defects are formed in the semiconductor substrate when manufacturing the IGBT.

This specification also discloses a new method for manufacturing an IGBT. This method manufactures the vertical IGBT comprising an emitter region, a body region, a drift region, a collector region, a floating region, and a gate electrode. The emitter region is a region of a first conductive type. The body region is a region of a second conductive type being adjacent to the emitter region at a deeper side of the emitter region. The drift region is a region of the first conductive type being adjacent to the body region at a deeper side of the body region and being divided from the emitter region by the body region. The collector region is a region of the second conductive type being adjacent to the drift region at a deeper side of the drift region and being divided from the body region by the drift region. The floating region is a region of the first conductive type being formed within the body region and being divided from both of the emitter region and the drift region by the body region. The gate electrode faces a range of the body region via an insulating film. This range divides the emitter region from the drift region. This method has a top body region injecting step, a bottom body region injecting step and a floating region injecting step. The top body region injecting step is a step of injecting second conductive type impurities to a semiconductor substrate. The second conductive type impurities are injected to a depth corresponding to the body region that is above the floating region. The bottom body region injecting step is a step of injecting the second conductive type impurities to the semiconductor substrate. The second conductive type impurities are injected to a depth corresponding to the body region that is under the floating region. The floating region injecting step is a step of injecting first conductive type impurities to the semiconductor substrate. The first conductive type impurities are injected to a depth corresponding to the floating region. Note that the top body region injecting step, the bottom body region injecting step, and the floating region injecting step can be performed in any order.

In this manufacturing method, the injection of the second conductive type impurities to the top body region and the injection of the second conductive type impurities to the bottom body region are performed independently. Therefore, in the manufactured IGBT, the density of the second conductive type impurities distributes such that the density decreases from an upper side to a lower side near the boundary between the floating region and the top body region, and increases from the upper side to the lower side near the boundary between the floating region and the bottom body region. Furthermore, because the first conductive type impurities are injected to the floating region, in the manufactured IGBT, the density of the first conductive type impurities is distributed such that the density increases from the upper side to the lower side near the boundary between the floating region and the top body region and decreases from the upper side to the lower side near the boundary between the floating region and the bottom body region. Therefore, the IGBTs can be manufactured while suppressing the production variation of the on-voltages.

In the method described above, the second conductive type impurities may preferably be injected in higher density in the top body region injecting step than in the bottom body region injecting step. Consequently, the maximum value of the density of the second conductive type impurities in the top body region becomes higher than the maximum value of the density of the second conductive type impurities in the bottom body region. Therefore, the IGBTs can be manufactured while suppressing the variation of the gate threshold voltages.

The method described above comprises a trench forming step, an oxide film forming step and a gate electrode forming step which are performed before the top body region injecting step, the bottom body region forming step and the floating region forming step. The trench forming step forms a trench at a top surface of the semiconductor substrate. The oxide film forming step may form an oxide film on an inner wall surface of the trench by a heat treatment. The gate electrode forming step forms the gate electrode in the trench. In the oxide film forming step and the gate electrode forming step, the heat treatment must be performed for the semiconductor substrate. Therefore, if the steps of forming trench structure (i.e. the trench forming step, the oxide film forming step and the gate electrode forming step) are performed after the steps of injecting impurities (i.e. top body region injecting step, bottom body region injecting step and the floating region injecting step), the injected impurities are diffused by the heat treatment in the steps of forming the trench structure. Consequently, the variation of the distribution of the density of the impurities in the IGBT is large and a factor of the variation of the characteristics of the IGBTs is increased. In the method described above, this problem is not caused because the steps of forming the trench structure are performed before the steps of injecting the impurities.

In the above described method for performing the steps of forming the trench structure according to the invention before the steps of injecting the impurities, a distance in a depth direction between a top surface of the gate electrode and the top surface of the semiconductor substrate is ensured to have more than or equal to 0.2 µm in the gate electrode forming step. When the trench structure has been formed, the concave portion is formed on the top surface of the semiconductor substrate by the upper portion of the gate electrode. When performing the steps of injecting the impurities after the steps of forming the trench structure, stop positions of the impurities injected near the trench vary by being affected by the concave portion. If the concave portion is shallow (i.e. less than 0.2 µm), the stop positions of the impurities vary greatly in accordance with the depth of the concave portion. On the other hand, if the concave portion is deep (i.e. more than or equal to 0.2 µm), the stop positions of the impurities do not vary so greatly even if the depths of the concave portions vary. Therefore, if the distance in a depth direction between a top surface of the gate electrode and the top surface of the semiconductor substrate (i.e. the depth of the concave portion) is more than or equal to 0.2 µm as described above, the variation of the stop positions of the impurities injected near the trench are suppressed. Therefore, variation of the gate threshold voltages of the IGBTs can be suppressed.

In the above described method for performing the steps of forming the trench structure before the steps of injecting impurities, the trench may preferably be formed at the top surface of the semiconductor substrate in the trench forming step so that the trench extends perpendicularly to a 011 crystal orientation of the semiconductor substrate. In the top body region injecting step, the bottom body region injecting step and the floating region injecting step, the first conductive type impurities and the second conductive type impurities may be injected, in a state with an angle between an injecting direction and a 100 crystal orientation of the semiconductor substrate around the 011 crystal orientation of the semiconductor substrate. If the relationship of the trench and the injecting direction of the impurities is made as described above, the impurities can be injected parallel to the wall surface of the trench. Furthermore, if the relationship of the crystal orientation of the semiconductor and the injecting direction of the impurities is made as described above, a channeling can be suppressed during the injection of the impurities. Therefore, the production variation of the characteristics of the IGBTs is further suppressed.

The IGBT provided by the technique disclosed in this specification includes a structure which can suppress the production variation of the characteristics. Furthermore, the manufacturing method provided by the technique disclosed in this specification can manufacture the IGBTs while suppressing the production variation of the characteristics.

### BRIEF DESCRIPTION OF THE DRAWINGS

Fig. 1 shows a cross sectional view of an IGBT 10;
Fig.2 is a graph showing a distribution of densities of impurities in the IGBT 10 along II-II line in Fig. 1;
Fig.3 is a graph showing a distribution of densities of impurities in a conventional IGBT along an area corresponding to Fig.2;
Fig.4 shows an enlarged view of Fig.2 (an enlarged view of a distribution of densities of impurities in a floating region 26);
Fig.5 shows an enlarged view of Fig.3 (an enlarged view of a distribution of densities of impurities in a floating region);
Fig.6 is a cross sectional view of a semiconductor substrate 70 to be used for manufacturing the IGBT 10;
Fig.7 shows a cross sectional view of the semiconductor substrate 70 after a lower side and peripheral side diffused layer forming step;
Fig.8 shows a cross sectional view of the semiconductor substrate 70 after a trench forming step;
Fig.9 is an explanation drawing of a direction of a trench 35;
Fig. 10 shows a cross sectional view of the semiconductor substrate 70 after a trench insulating film and gate electrode forming step;
Fig. 11 shows a cross sectional view of the semiconductor substrate 70 in a case where a trench recess depth H1 is 0.3 µm;
Fig. 12 shows a cross sectional view of the semiconductor substrate 70 in a bottom body region injecting step, a floating region injecting step and a top body region injecting step;
Fig. 13 shows a cross sectional view of the semiconductor substrate 70 in an emitter region injecting step;
Fig. 14 shows a cross sectional view of a semiconductor substrate 70 in a body contact region injecting step;
Fig. 15 is an explanation drawing of an ion injecting direction;
Fig. 16 shows a cross sectional view of the semiconductor substrate 70 in a case where the trench recess depth H1 is 0 µm not forming part of the claimed invention;
Fig. 17 shows a cross sectional view of the semiconductor substrate 70 in a case where the trench recess depth H1 is 0.6 µm;
Fig. 18 shows a graph indicating a relationship between the trench recess depth H1 and a peak value of a density of p-type impurities in a channel 40;
Fig. 19 shows a graph indicating a relationship between the trench recess depth H1 and a gate threshold voltage of the IGBT 10;
Fig.20 shows a graph indicating a relationship between the trench recess depth H1 and the gate threshold voltage of the IGBT 10 in a case where the ion injecting direction is adjusted; and
Fig.21 is an explanation drawing showing an orientation to cut out a semiconductor substrate from an ingot by a manufacturing method of an alternative embodiment.

### DETAILED DESCRIPTION OF THE PREFERED EMBODIMENTS

The compositions of an example useful for understanding the invention which will be described later in detail are first explained.

(Feature 1) A density of second conductive type impurities within a floating region decreases from an upper end to a lower side to reach a local minimum value, and increases from a depth where the local minimum value is obtained towards a lower end.

(Feature 2) A density of first conductive type impurities within the floating region increases from the upper end to the lower side to reach a local maximum value, and increases from a depth where the local maximum value is obtained towards the lower end.

(Feature 3) A density of the second conductive type impurities within a body region above the floating region increases from an upper end to a lower side to reach a local maximum value, and decreases from a depth where the local maximum value is obtained towards a lower end.

(Feature 4) A density of the second conductive type impurities within a body region under the floating region increases from an upper end to a lower side to reach a local maximum value, and decreases from a depth where the local maximum value is obtained towards a lower end.

### Example useful for understanding the invention

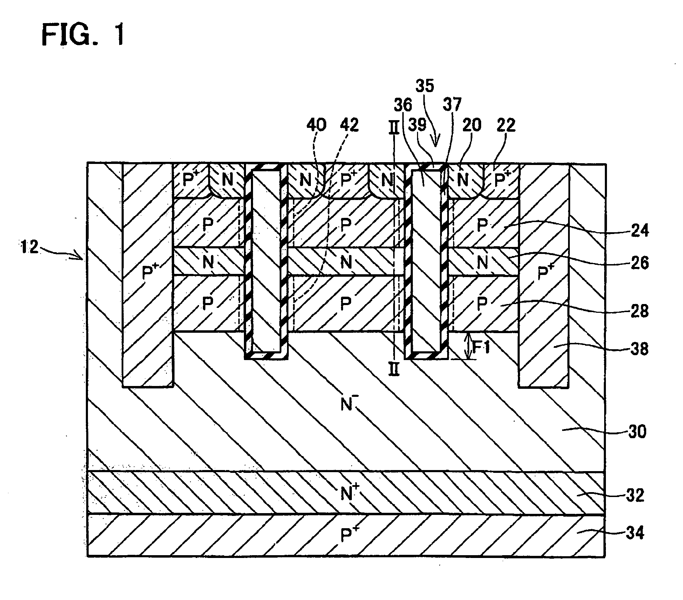

The following provides an explanation of an IGBT of the example useful for understanding the invention with reference to the drawings. FIG. 1 shows a cross-sectional view of an IGBT 10 of this example useful for understanding the invention. The IGBT 10 has an emitter region 20, a body contact region 22, a top body region 24, a floating region 26, a bottom body region 28, a drift region 30, a buffer region 32, a collector region 34, a gate electrode 36 and a peripheral blocking region 38. The emitter region 20 is an n-type region. The emitter region 20 is selectively formed within a range that exposes on the top surface of a semiconductor substrate 12. The body contact region 22 is a p-type region including a high density of p-type impurities. The body contact region 22 is selectively formed within a range that exposes on the top surface of the semiconductor substrate 12. The body contact region 22 is formed so as to be adjacent to the emitter region 20. The top body region 24 is a p-type region, and is formed on the lower side of the emitter region 20 and the body contact region 22. The floating region 26 is an n-type region, and is formed on the lower side of the top body region 24. The floating body region 26 is divided from the emitter region 20 by the top body region 24. In addition, the floating region 26 is divided from the drift region 30 by the bottom body region 28. The bottom body region 28 is a p-type region, and is formed on the lower side of the floating region 26. The drift region 30 is an n-type region including a low density of n-type impurities. The drift region 30 is formed on the lower side of the bottom body region 28. The buffer region 32 is an n-type region including a high density of n-type impurities. The buffer region 32 is formed on the lower side of the drift region 30. The collector region 34 is a p-type region including a high density of p-type impurities. The collector region 34 is formed within an entire of a range that exposes on the bottom surface of the semiconductor substrate 12. A trench 35 is formed on the top surface of the semiconductor substrate 12 so as to penetrate the emitter region 20, the top body region 24, the floating region 26 and the bottom body region 28, and reach the drift region 30. The inner surface of the trench 35 is covered with a trench insulating film 37. The gate electrode 36 is formed within the trench 35. Namely, the gate electrode 36 faces, via the trench insulating film 37, a range of the top body region 24, the floating region 26 and the bottom body region 28, which divides the emitter region 20 and the drift region 30, The top surface of the gate electrode 36 is covered with a cap insulating film 39. However, the gate electrode 36 can be connected to an external component at a location not shown in the drawing. The peripheral blocking region 38 is a p-type region including a high density of p-type impurities. The peripheral blocking region 38 is formed within a depth range from the upper surface of the semiconductor substrate 12 to a position deeper than the lower end of the trench 35. The peripheral blocking region 38 is formed along the periphery of the semiconductor substrate 12. Namely, the peripheral blocking region 38 is formed so as to surround the periphery of an IGBT region (region in which the emitter region 20, the body contact region 22, the top body region 24, the floating region 26, the bottom body region 28 and the gate electrode 36 are formed).

During operation of the IGBT 10, a voltage is applied between an emitter electrode (not shown), which is formed on the surfaces of the emitter region 20 and the body contact region 22, and a collector electrode (not shown), which is formed on the surface of the collector region 34. In addition, a voltage is applied to the gate electrode 36. As a result of applying the voltage to the gate electrode 36, a channel 40 is formed within a range of the top body region 24 that contacts with the trench insulating film 37, and a channel 42 is formed within a range of the bottom body region 28 that contacts with the trench insulating film 37. Consequently, electrons flow from the emitter region 20 to the collector region 34 via the channel 40, the floating region 26, the channel 42, the drift region 30 and the buffer region 32. In addition, holes flow from the collector region 34 to the body contact region 22 via the buffer region 32, the drift region 30, the bottom body region 28, the floating region 26 and the top body region 24. However, since the floating region 26 becomes a barrier to the flow of holes, numerous holes are accumulated within the drift region 30. Consequently, the density of holes within the drift region 30 increases, and the electrical resistance of the drift region 30 decreases due to a conductivity modulation phenomenon. Thus, the IGBT 10 operates at a low on-voltage (collector-emitter voltage). Namely, power loss of the IGBT 10 during operation is low.

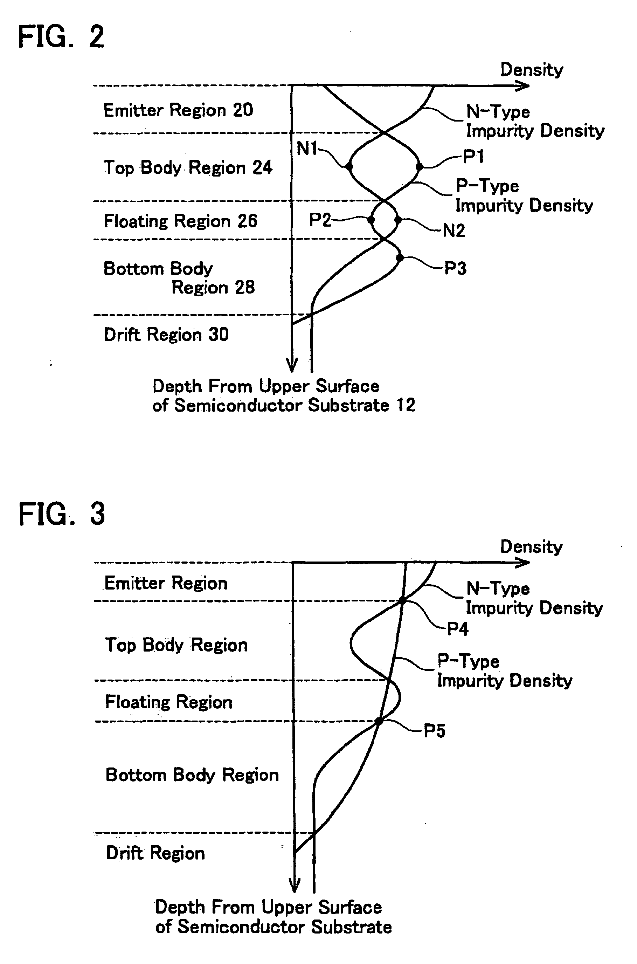

FIG. 2 shows the distribution of n-type impurity density and p-type impurity density within the IGBT 10 as viewed along line II-II of FIG. 1. As shown in FIG 2, an n-type impurity density is at maximum at the upper end of the emitter region 20. The n-type impurity density decreases from the upper end of the emitter region 20 towards the lower side, and reaches a local minimum value N1 within the top body region 24. The n-type impurity density increases from the depth where the local minimum value N1 is obtained towards the lower side, and reaches a local maximum value N2 within the floating region 26. The n-type impurity density decreases from the depth where the local maximum value N2 is obtained towards the lower side, and becomes a roughly constant value within the drift region 30. On the other hand, a p-type impurity density increases from the upper end of the emitter region 20 to the lower side, and reaches a local maximum value P1 within the top body region 24. The p-type impurity density decreases from the depth where the local maximum value P1 is obtained towards the lower side, and reaches a local minimum value P2 within the floating region 26. The p-type impurity density increases from the depth where the local minimum value P2 is obtained towards the lower side, and reaches a local maximum value P3 within the bottom body region 28. The p-type impurity density decreases from the depth where the local maximum value P3 is obtained towards the lower side, and becomes roughly zero within the drift region 30. As will be subsequently described in detail, the reason for the p-type impurity density having the local maximum values P1 and P3 and the local minimum value P2 is that p-type impurity injecting steps are performed on the top body region 24 and the bottom body region 28, respectively, during manufacturing of the IGBT 10.

In addition, FIG. 3 shows impurity densities corresponding to FIG. 2 in a conventional IGBT having a floating region. In the conventional IGBT, the n-type impurity density is distributed in roughly the same profile as the IGBT 10 of the present embodiment. On the other hand, p-type impurity density is at maximum at the upper end of an emitter region, decreases gradually from the upper end of the emitter region to the lower side, and becomes roughly zero within a drift region. Consequently, in the conventional IGBT, the p-type impurity density is distributed smoothly without having any local maximum or local minimum value. The reason for the smooth distribution of the p-type impurity density is that, in a conventional IGBT manufacturing method, p-type impurities are injected comparatively uniformly to the entire IGBT region (namely, the emitter region, body contact region, top body region, floating region and bottom body region), after which the p-type impurities are diffused by heat treatment.

The IGBT 10 of the present embodiment shown in FIG. 2 is more resistant to the occurrence of production variation in the width of the floating region 26 in comparison with the conventional IGBT shown in FIG. 3. The reasons for this are explained below. FIG. 4 shows an enlarged view of the distribution of impurity densities within the floating region 26 of FIG. 2. In addition, FIG. 5 shows an enlarged view of the distribution of impurity densities within the floating region of FIG. 3. Furthermore, in FIG. 4, the solid line of graph A1 indicates the designed value of density of the n-type impurities of the IGBT 10, while the dotted lines of graphs A2 and A3 indicate the n-type impurity densities when predetermined variations from the designed value have occurred. Similarly, in FIG. 5, the solid line of graph B1 shows the designed value of the n-type impurities of the conventional IGBT, while the dotted lines of graphs B2 and B3 show the n-type impurity densities when predetermined variations from the designed value have occurred. As shown in FIG. 4, in the IGBT 10 of the present embodiment, when n-type impurity density is low just like the distribution shown in graph A2, the width of the floating region 26 (namely, the width of the region where n-type impurity density is higher than p-type impurity density) is narrowed (see width W1 of FIG. 4). On the other hand, when the n-type impurity density is high just like the distribution shown in graph A3, the width of the floating region 26 is widened (see width W2 of FIG. 4). Thus, if variations in n-type impurity density occur between graph A2 and graph A3 during production of the IGBTs 10, the widths of the floating regions 26 of the IGBTs 10 vary between width W1 and width W2. In the conventional IGBT as shown in FIG. 5, when the n-type impurity density is low (see graph B2), the width of the floating region is width W3. When the n-type impurity density is high (see graph B3), the width of the floating region is width W4. As is clear from a comparison of FIGS. 4 and 5, the difference between width W1 and width W2 is smaller than the difference between width W3 and width W4. Namely, in the IGBT 10 of the present embodiment, even in the case that variation has occurred in n-type impurity density to the same degree as in a conventional IGBT, it is more unlikely for variation in the width of the floating region to occur as compared with a conventional IGBT.

Consequently, the reason why it is more unlikely for variation in the width of the floating region to occur in the IGBT 10 of the present embodiment than in the conventional IGBT can be understood as follows. In the conventional IGBT, since the p-type impurity density is distributed comparatively uniformly, the p-type impurity density does not change greatly in the vicinity of both boundaries of the floating region (i.e. the boundary with the top body region and boundary with the bottom body region). In contrast, in the IGBT 10 of the present embodiment as shown in FIG. 5, the p-type impurity density decreases from the upper side to the lower side while the n-type impurity density increases from the upper side to the lower side in the vicinity of the boundary between the floating region 26 and the top body region 24. In other words, the graph of the p-type impurity density and the graph of the n-type impurity density intersect at a sharp angle. Consequently, even if there is variation in the n-type impurity density, there is hardly any variation in the location of the boundary between the floating region 26 and the top body region 24. Similarly, the p-type impurity density increases from the upper side to the lower side while the n-type impurity density decreases from the upper side to the lower side at the boundary between the floating region 26 and the bottom body region 28. Namely, the graph of the p-type impurity density and the graph of the n-type impurity density intersect at a sharp angle. Consequently, even if there is variation in the n-type impurity density, there is hardly any variation in the location of the boundary between the floating region 26 and the bottom body region 28. Thus, it is more unlikely for variation in the width of the floating region 26 to occur in the IGBT 10 of the present embodiment than in the conventional IGBT when the production variations in the n-type impurity density have occurred. Note that FIGS. 4 and 5 are used to explain the case in which the production variation has occurred in the n-type impurity density, however, the width of the floating region 26 is determined by the distributions of both the p-type impurity density and the n-type impurity density. Consequently, the same can be said for cases in which production variations in the p-type impurity density have occurred. Namely, it is more unlikely for the variation in the width of the floating region 26 to occur in the IGBT 10 of the present embodiment than in the conventional IGBT even in the case where production variations in the p-type impurity density have occurred.

The width of the floating region 26 greatly affects on-voltage of the IGBT 10. Namely, as shown in FIG. 1, the channels 40 and 42 are formed on the upper side and lower side of the floating region 26 when the IGBT 10 is on. If the width of the floating region 26 varies, the lengths of the channels 40 and 42 also vary. Consequently, the on-voltage of the IGBT 10 varies. In the IGBT 10 of the present embodiment, since it is unlikely for the width of the floating region 26 to vary, it is unlikely for production variation of the on-voltage to occur during mass production of the IGBT.

In addition, the on-voltage of the IGBT 10 also varies due to the effects of density difference between the p-type impurities and the n-type impurities within the floating region 26. In other words, the size of the barrier upon the holes flowing to the body contact region 22 fluctuates according to the density difference within the floating region 26. Variation in the size of the barrier causes variation in the ability of the holes to accumulate within the drift region 30 when the IGBT 10 is on. Consequently, the on-voltage of the IGBT 10 varies. As shown in FIG. 2, in the IGBT 10 of the present embodiment, the local maximum value N2 of n-type impurity density and the local maximum value P2 of p-type impurity density exist in the floating region 26. Consequently, as is clear from a comparison of FIGS. 2 and 3, the density difference between the n-type impurities and the p-type impurities within the floating region 26 is larger than in the conventional IGBT. Consequently, the effect on the density difference is small even if there are variations in the p-type impurity density and the n-type impurity density within the floating region 26. For this reason as well, it is unlikely for variation in on-voltage of the IGBT 10 to occur during the mass production.

In addition, a minimum gate voltage required to form the channel 40 (to be referred to as a gate threshold voltage) is greatly dependent on the maximum value of p-type impurity density within the top body region 24. The larger the maximum value of p-type impurity density within the top body region 24 is, the larger the gate threshold voltage for the channel 40 is. In a conventional IGBT as shown in FIG. 3, a maximum value P4 of p-type impurity density within a top body region exists at the boundary with an emitter region. Consequently, the maximum value P4 varies greatly due to the effects of both of production variation in p-type impurity density and production variation in n-type impurity density. On the other hand, in the IGBT 10 of the present embodiment, the maximum value of p-type impurity density within the top body region 24 is the local maximum value P1. This local maximum value P1 is not affected by production variation in n-type impurity density. Consequently, it is more unlikely for the variation to occur in the local maximum value P1 than in the maximum value P4 of a conventional IGBT. Consequently, in the IGBT 10 of the present embodiment, it is unlikely for the variations to occur in the gate threshold voltage for the channel 40 during the mass production.

In addition, the gate threshold voltage required to form the channel 42 is greatly dependent on the maximum value of the p-type impurity density within the bottom body region 28. The larger the maximum value of p-type impurity density within the bottom body region 28 is, the larger the gate threshold voltage for the channel 42 is. In the conventional IGBT as shown in FIG. 3, a maximum value P5 of p-type impurity density within a bottom body region exists at the boundary with the floating region. Consequently, the maximum value P5 varies greatly due to the effects of both of production variation in p-type impurity density and production variation in the n-type impurity density. On the other hand, in the IGBT 10 of the present embodiment, the maximum value of p-type impurity density within the bottom body region 28 is the local maximum value P3. This local maximum value P3 is not affected by the production variation in the n-type impurity density. Consequently, it is more unlikely for the variation to occur in the local maximum value P3 than the maximum value P5 of the conventional IGBT. Consequently, in the IGBT 10 of the present embodiment, it is unlikely for the variations to occur in the gate threshold voltage for the channel 42 during the mass production.

In addition, the overall gate threshold voltage required to create electrical continuity between the emitter region 20 and the drift region 30 is determined by the larger one of the gate threshold voltage for the channel 40 and the gate threshold voltage for the channel 42. Since a difference in the behavior of the electrons that pass through the channels 40 and 42 occurs between a case in which the gate threshold voltage for the channel 40 is larger and a case in which the gate threshold voltage for the channel 42 is larger, the characteristics of the IGBT 10 differ. Consequently, if the gate threshold voltage for the channel 40 (namely, the local maximum value P1) and the gate threshold voltage for the channel 42 (namely, the local maximum value P3) are roughly equal values, the variation occurs in the characteristics of the IGBT 10 because the case in which the local maximum value P1 is larger or the local maximum value P3 is larger occurs due to the production variation. In the IGBT 10 of the present embodiment, since the local maximum value P1 is larger than the local maximum value P3, the overall gate threshold voltage is determined by the local maximum value P1 (namely, the gate threshold voltage for the channel 40). Thus, the variation in the characteristics of the IGBT 10 can be further reduced. In addition, in the case where the local maximum value P1 within the top body region 24 is larger, a larger amount of the p-type impurities are injected into the top body region 24 than the bottom body region 28 during production of the IGBT 10. Since the top body region 24 is formed at a shallower location than the bottom body region 28, the formation of crystal defects in the semiconductor substrate 12 during injection of impurities can be suppressed to a greater degree than in the case of injecting a large amount of p-type impurities into the bottom body region 28. In addition, in the case of injecting the large amount of p-type impurities into the bottom body region 28, variation of the location of the lower end of the bottom body region 28 (location in the direction of thickness) also increases. Thus, the variation occurs in a distance from the lower end of the bottom body region 28 to the lower end of the trench 35 (distance F1 in FIG. 1; namely, the distance the trench 35 protrudes from the lower end of the bottom body region 28), and this causes the variations in the withstand voltage characteristics of the IGBT 10. This problem does not occur if the local maximum value P1 is larger than the local maximum value P3, since the large amount of p-type impurities are not injected into the bottom body region 28 in such cases.

In addition, in the IGBT 10 of the present embodiment, the local maximum value P1 of the p-type impurity density and the local minimum value N1 of the n-type impurity density exist in the top body region 24. As a result, the density difference between the p-type impurities and the n-type impurities in the top body region 24 is large. Due to this large density difference, the effect of the variations in the densities of the p-type impurities and the n-type impurities in the top body region 24 becomes smaller. For this reason as well, the variations are made more unlikely to occur in the characteristics of the IGBT 10.

In addition, in the IGBT 10 of the present example, the local maximum value P3 of the p-type impurity density exists in the bottom body region 28. As a result, the density difference between the p-type impurities and the n-type impurities in the bottom body region 28 is large. Due to this large density difference, the effect of the variations in the densities of p-type impurities and n-type impurities in the bottom body region 28 becomes smaller. For this reason as well, the variations are made more unlikely to occur in the characteristics of the IGBT 10. In particular, the p-type impurity densities are distributed smoothly in the conventional IGBT as shown in FIG. 3. Consequently, when the p-type impurity density of the bottom body region is increased in an attempt to ensure the density difference with the n-type impurity density, the bottom body region had to be formed extending to a considerably deep location. Consequently, it was also necessary to form the trench extending to a deep location, thereby resulting in the problem of poor production efficiency. In the IGBT 10 of the present embodiment, the p-type impurity density within the bottom body region 28 is locally high (namely, the local maximum value P3). Consequently, although there is a large density difference between the p-type impurity density and the n-type impurity density in the bottom body region 28, the bottom body region 28 does not extend to so deep (see FIGS. 2 and 3). More specifically, whereas the lower end of the bottom body region of the conventional IGBT is located about 4.5 µm from the top surface of the semiconductor substrate, the lower end of the bottom body region 28 of the IGBT 10 of the present embodiment is located about 3.3 µm from the top surface of the semiconductor substrate 12. Consequently, since the bottom body region 28 is not formed to reach that deep, the depth of the trench 35 can also be comparatively shallow. Thus, the IGBT 10 can be produced more efficiently than the conventional IGBT.

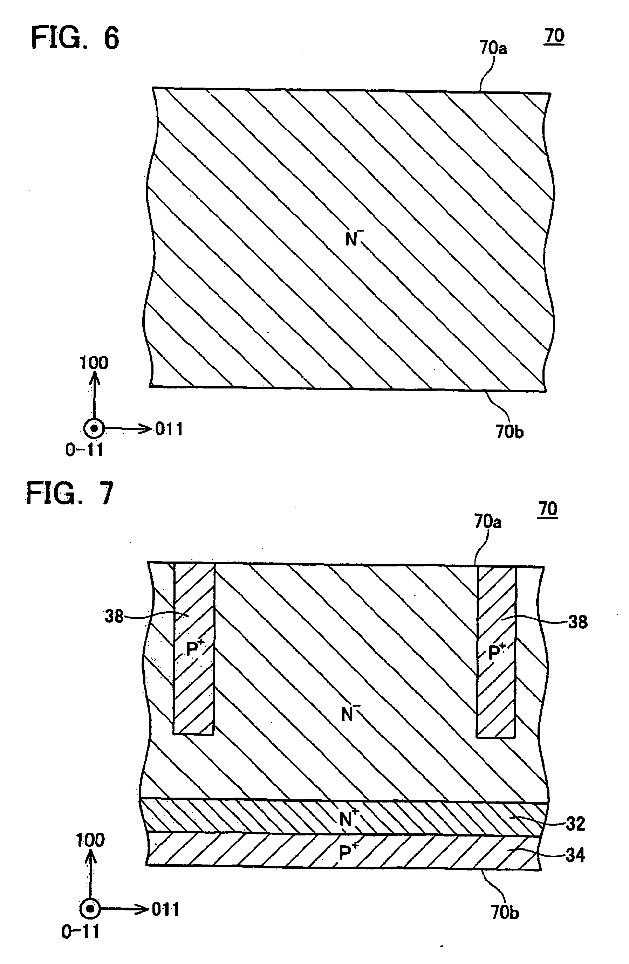

Next, an explanation is provided of a manufacturing method of the IGBT 10. The IGBT 10 is manufactured from a semiconductor substrate 70 shown in FIG. 6. A top surface 70a of the semiconductor substrate 70 is a 100 plane perpendicular to the 100 crystal orientation. The semiconductor substrate 70 has the n-type impurity density equal to that of the drift region 30.

### (Lower Side and Peripheral Side Diffused Layer Forming Step)

First, the buffer region 32 and the collector region 34 are formed in an area of the bottom surface 70b side in the semiconductor substrate 70 as shown in FIG. 7 by performing ion injection and heat diffusion. The peripheral blocking region 38 is similarly formed in an area of the top surface 70a side in the semiconductor substrate 70.

### (Trench Forming Step)

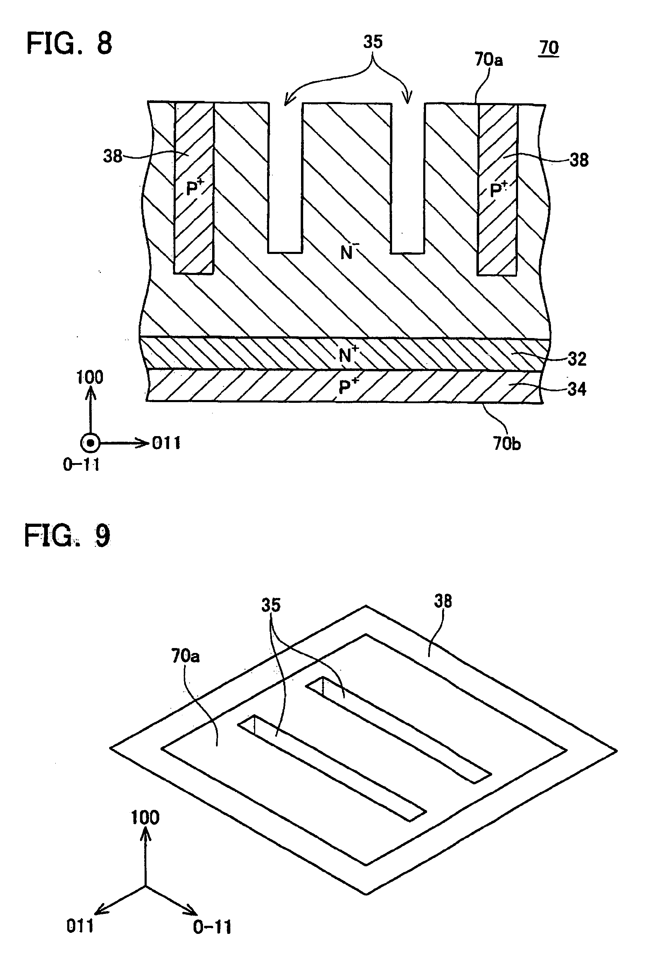

Next, the trench 35 is formed on the top surface 70a of the semiconductor substrate 70 by etching using reactive ion etching (RIE) as shown in FIG. 8. Furthermore, as shown in FIG. 9, the trench 35 is formed on the top surface 70a of the semiconductor substrate 70 so as to extend perpendicular to a 011 crystal orientation of the semiconductor substrate 70 (namely, so as to extend along a 0-11 crystal orientation).

### (Trench Insulating Film and Gate Electrode Forming Step)

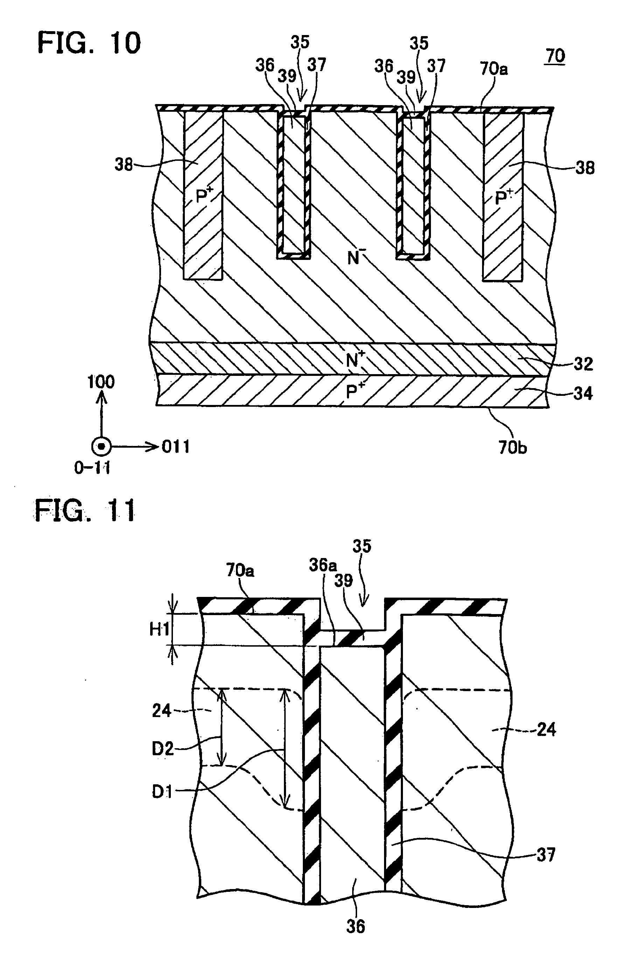

Once the trench 35 has been formed, a sacrificial oxide film is formed on the surface of the semiconductor substrate 70 and the inner surface of the trench 35 by heat-treating the semiconductor substrate 70. Subsequently, the sacrificial oxide film is removed by etching. Once the sacrificial oxide film has been removed, a silicon oxide film is formed on the surface of the semiconductor substrate 70 and the inner surface of the trench 35 by again heat-treating the semiconductor substrate 70. The silicon oxide film inside the trench 35 serves as the trench insulating film 37. Once the trench insulating film 37 has been formed, polysilicon is deposited on the semiconductor substrate 70 by chemical vapor deposition (CVD). At this time, polysilicon is filled into the trench 35. Once the polysilicon has been deposited, polysilicon outside the trench 35 is removed by etching such as chemical dry etching (CDE). As a result, polysilicon remaining within the trench 35 becomes the gate electrode 36. Once the gate electrode 36 has been formed, the cap insulating film 39 is formed on the top surface of the gate electrode 36 by heat-treating the semiconductor substrate 70. As a result, the cross-sectional structure of the semiconductor substrate 70 becomes the structure shown in FIG. 10. FIG. 11 shows an enlarged view of the vicinity of the top surface of the gate electrode 36 of the cross-sectional view of FIG. 10. As shown in FIG. 11, the gate electrode 36 is formed so that a top surface 36a thereof is located lower than the top surface 70a of the semiconductor substrate 70. Thus, a concave portion is formed on the top surface 70a of the semiconductor substrate 70. In the present embodiment, the gate electrode 36 is formed so that a height H1 of the level difference between the top surface 36a of the gate electrode 36 and the top surface 70a of the semiconductor substrate 70 (to be referred to as "trench recess depth H1") is about 0.3 µm.

### (Ion Injecting Steps)

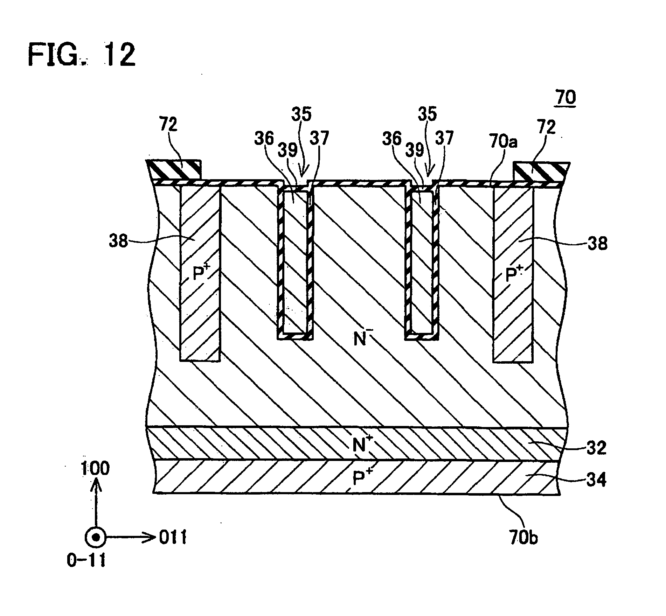

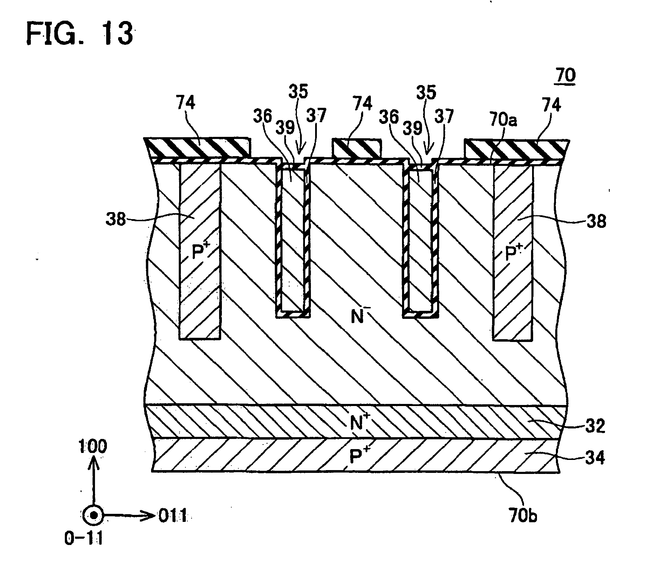

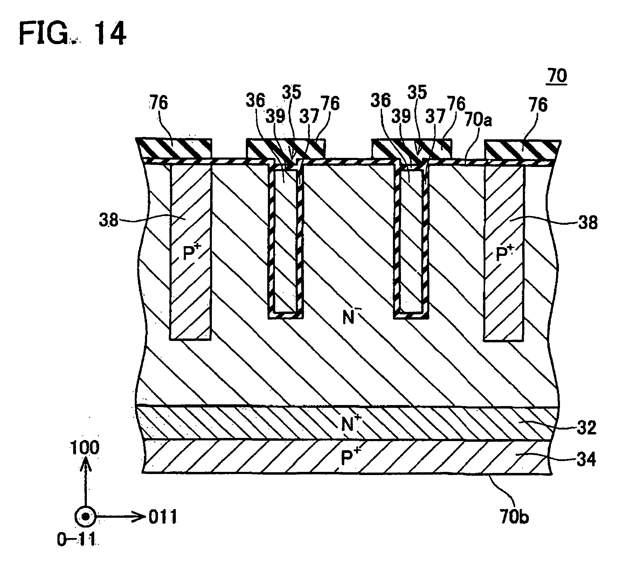

Next, as shown in FIG. 12, a resist 72 is formed on the top surface 70a of the semiconductor substrate 70 and outside the peripheral blocking region 38. Namely, the resist 72 is formed while leaving the IGBT region uncovered. Ions are then injected into the semiconductor substrate 70 from the top surface 70a side. First, the p-type impurities are injected to a depth corresponding to the bottom body region 28 (bottom body region injecting step). Namely, the p-type impurities are injected by adjusting an acceleration voltage so that the injected p-type impurities stop within the range of the depth corresponding to the top body region 28. More specifically, the p-type impurities are injected so that the peak of a stop position of the injected p-type impurities is at the depth of the local maximum value P3 of FIG. 2. Next, the n-type impurities are injected to a depth corresponding to the floating region 26 (floating region injecting step). Namely, the n-type impurities are injected by adjusting the acceleration voltage so that the injected n-type impurities stop within the range of the depth corresponding to the floating region 26. More specifically, the n-type impurities are injected so that the peak of a stop position of the injected n-type impurities is at the depth of the local maximum value N2 of FIG. 2. Next, the p-type impurities are injected to a depth corresponding to the top body region 24 (top body region injecting step). Namely, the p-type impurities are injected by adjusting the acceleration voltage so that the injected p-type impurities stop within the range of the depth corresponding to the top body region 24. More specifically, the p-type impurities are injected so that the peak of a stop position of the p-type impurities is at the depth of the local maximum value P1 of FIG. 2. Furthermore, in the top body region injecting step, the p-type impurities are injected at a higher density than in the bottom body region injecting step. Next, the resist 72 is removed and a resist 74 is newly formed as shown in FIG. 13. The resist 74 is formed so as to cover a region corresponding to the body contact region 22 and a region outside the peripheral blocking region 38. Next, the n-type impurities are injected to a depth corresponding to the emitter region 20 (namely, a surface layer portion) from the top surface 70a side (emitter region injecting step). Next, the resist 74 is removed and a resist 76 is newly formed as shown in FIG. 14. The resist 76 is formed so as to cover a region corresponding to the emitter region 20 and a region outside the peripheral blocking region 38. Next, the p-type impurities are injected to a depth corresponding to the body contact region 22 (namely, the surface layer portion) from the top surface 70a side (body contact region injecting step).

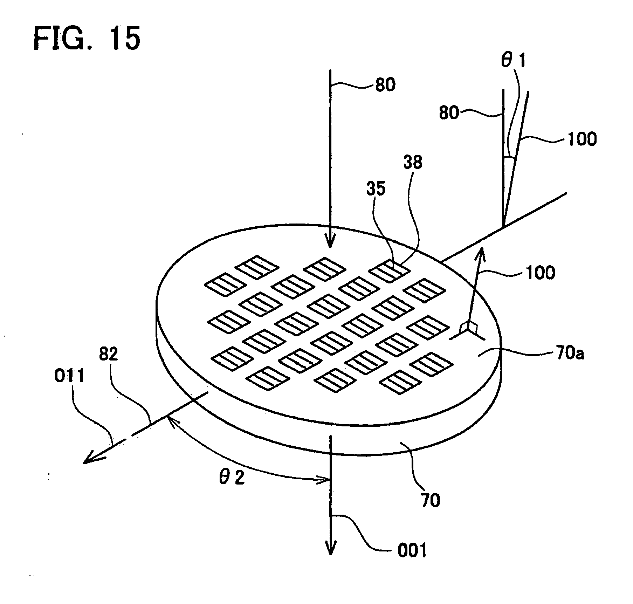

FIG. 15 indicates the positional relationship between an ion injecting direction and a crystal orientation of the semiconductor substrate 70 in the above-mentioned ion injecting steps (namely, the bottom body region injecting step, the floating region injecting step, the top body region injecting step, the emitter region injecting step and the body contact region injecting step). An arrow 80 in FIG. 15 indicates the ion injecting direction. As was previously described, the top surface 70a of the semiconductor substrate 70 is the 100 plane. In addition, the trench 35 is formed perpendicular to the 011 crystal orientation. In the ion injecting steps, ions are injected in a state where the 011 crystal orientation is coincident with a central axis 82, and the top surface 70a of the semiconductor substrate 70 is tilted relative to the ion injecting direction 80 centering around the central axis 82. Namely, the ions are injected in a state in which an angle θ1 (to be referred to as a tilt angle θ1) is formed between the ion injecting direction 80 and the 100 crystal orientation centering around the central axis 82. In the present embodiment, the tilt angle θ1 is 7.1°.

### (Heat Diffusing Step)

Once the ion injections have been completed, the semiconductor substrate 70 is heat-treated. When the heat treatment is performed, the injected impurities are diffused and activated. As a result, as shown in FIG. 1, the emitter region 20, the body contact region 22, the top body region 24, the floating region 26 and the bottom body region 28 are formed. As was previously described, since the ion injection is performed on each of the top body region 24, the floating region 26 and the bottom body region 28, the distribution of the impurity densities in these regions becomes as shown in FIG. 2. Namely, the local maximum value P1 is formed in the top body region 24, the local maximum value N2 is formed in the floating region 26, and the local maximum value P3 is formed in the bottom body region 28. In addition, since a step of injecting the p-type impurities is not performed so as to stop within the floating region 26, the local minimum value P2 is formed in the floating region 26.

Once the heat diffusing step has been completed, the required wiring, insulating films and the like (not shown) are formed on the surface of the semiconductor substrate 70. Subsequently, the semiconductor substrate 70 is divided by dicing. As a result, the IGBT 10 is completed. As has been explained above, the IGBT 10 of FIG. 1 can be manufactured with the density distribution shown in FIG. 2 by the manufacturing method described above.

In addition, the ion injecting steps are performed after the trench insulating film and gate electrode forming step. In general, the trench insulating film and gate electrode forming step is performed after forming the diffused regions (namely, after performing the ion injecting steps and the heat diffusing step). However, the following problems occur if the trench insulating film and gate electrode forming step is performed after forming the diffused regions. As was previously described, high-temperature heat treatment is performed in the trench insulating film and gate electrode forming step. If the heat treatment of the trench insulating film and gate electrode formation step is performed after forming the diffused regions, the impurities within the diffused regions are further diffused. As a result, the diffused regions expand, an outward diffusion occurs, or the impurities are unevenly deposited (pile up) within the trench insulating film. The occurrence of these phenomena causes the problem of unstable characteristics of the manufactured IGBT. In addition, when thermal oxidation treatment of the semiconductor substrate (formation of the sacrificial oxide film and the trench insulating film 37) is performed after the ion injection, oxidation-induced stacking faults (OSF) are easily formed as origins of crystal defects formed during ion injection. The OSF are defects in which interstitial silicon occurs at the interface between a silicon layer and silicon oxide layer during the thermal oxidation treatment, and the interstitial silicon diffuses within the silicon layer and grows in association with the crystal defects within the silicon layer. When the OSF are formed within the silicon layer, the problem occurs in which the IGBT leaks easily. In the manufacturing method of the present embodiment, the problems described above do not occur since the ion injecting steps are performed after the trench insulating film and gate electrode forming step. Characteristics of the manufactured IGBT 10 can be stabilized and the occurrence of the leakage defects in the IGBT 10 can be suppressed.

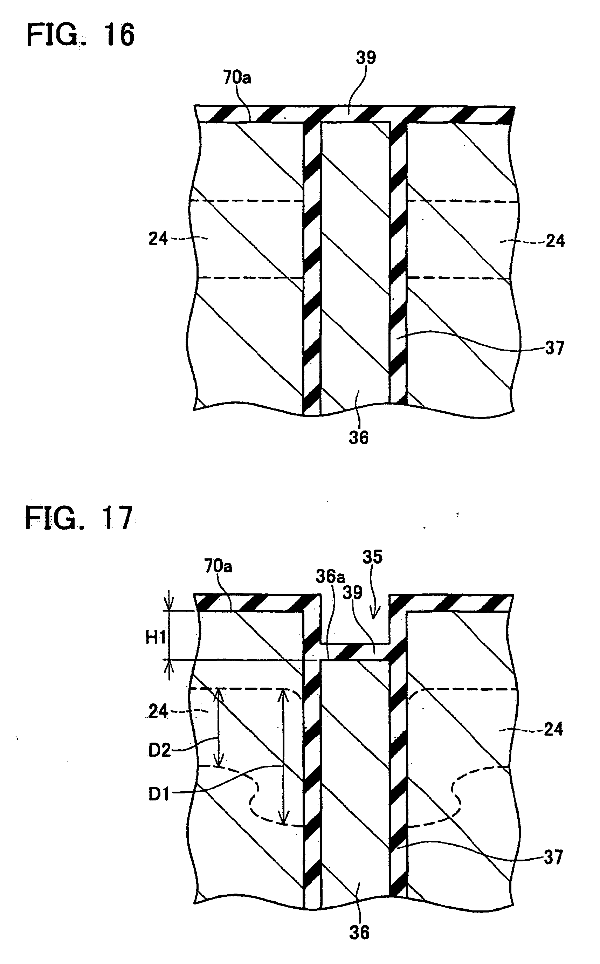

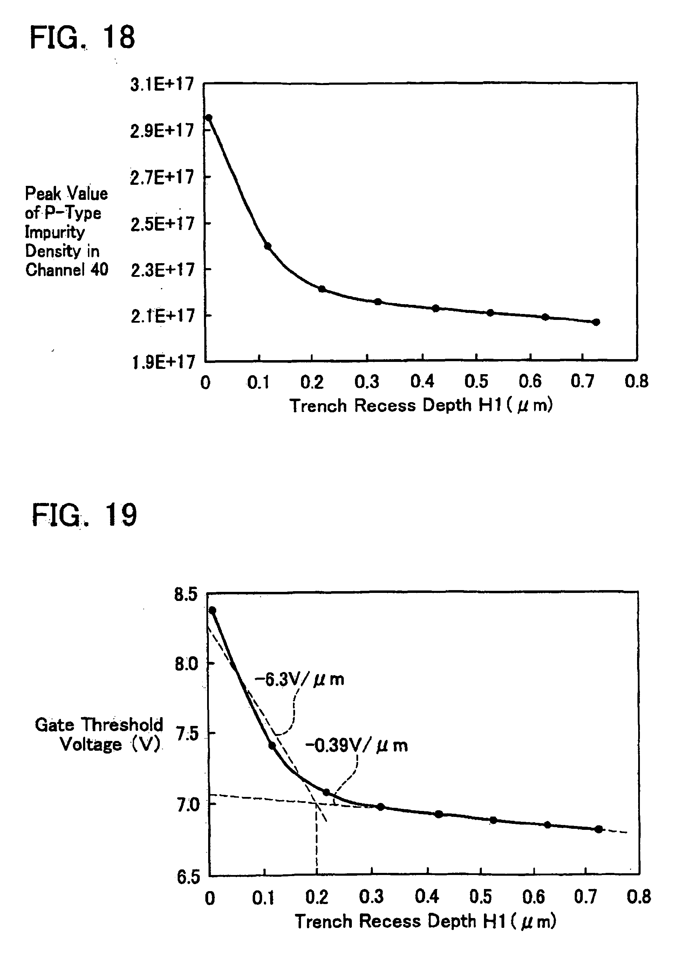

Note that, when the ion injecting steps are performed after the trench insulating film and gate electrode forming step as in the embodiment described above, the density at which the ions are injected into the top body region 24 (namely, the channel 40) near the trench insulating film 37 is affected by the shape of the gate electrode 36. Since the production variation occurs in the above-mentioned trench recess depth H1, the density at which the ions are injected into the top body region 24 near the trench insulating film 37 varies due to the variation of the trench recess depth H1. As a result, there is the problem in which the variations occur in the gate threshold voltage of the IGBT 10. However, in the manufacturing method of the present embodiment, the variations in gate threshold voltage caused by the variations in the trench recess depth H1 are minimally suppressed. The following provides an explanation of the reason for this. FIG. 16 is a cross-sectional view of the semiconductor substrate 70 prior to the top body region injecting step in a case where the trench recess depth H1 (see FIG. 11) is 0 µm not forming part of the claimed invention. A range 24 in FIG. 16 indicates a range over which the top body region 24 is formed in this case (case in which the ion injecting steps and the heat diffusing step are performed in a state in which the trench recess depth H1 is 0 µm). Since a concave portion is not formed in the trench recess portion in this case, in the top body region injection step, there is hardly any change in the stop positions of the p-type impurities injected near the trench insulating film 37 and other portions. Thus, as shown in FIG. 16, the top body region 24 is formed at roughly a constant depth and a constant width. As has been described above, in the manufacturing method of the present embodiment, the trench recess depth H1 is about 0.3 µm as shown in FIG 11. The region 24 of FIG 11 indicates the range over which the top body region 24 is formed in the case where the IGBT 10 is manufactured in the state in which the trench recess depth H1 is about 0.3 µm. In the case where the trench recess depth H1 is 0.3 µm, the top body region forming step is affected by the shape of the trench recess portion. Thus, the injected p-type impurities are more likely to stop at a deeper location as they are injected closer to the trench insulating film 37. Consequently, as shown in FIG. 11, the top body region 24 is formed in a shape of being displaced to the deeper location as it is closer to the trench insulating film 37. Consequently, since the top body region 24 is displaced near the trench insulating film 37, a width D1 of the top body region 24 near the trench insulating film 37 becomes wider than a width D2 of the top body region 24 in another portion. Consequently, the density of p-type impurities of a portion having this width D1 (namely, the region where the channel 40 of FIG. 1 is formed (to be referred to as a channel region 40)) is small. FIG. 17 shows a cross-sectional view of a semiconductor substrate prior to the top body region injecting step in a case where the trench recess depth H1 is 0.6 µm. The range 24 of FIG. 17 indicates the range over which the top body region 24 is formed in this case. As is clear from a comparison of FIGS. 11 and 17, when the trench recess depth H1 is increased from 0.3 µm to 0.6 µm, although the portion of width D1 of the top body region 24 becomes broader (broader in the lateral direction of FIG. 17), the width D1 does not increase so much. Thus, in the case where the trench recess depth H1 is 0.6 µm, the density of p-type impurities of the portion of width D1 (namely, the channel region 40 of FIG. 1) does not decrease so much in comparison with the case where the trench recess depth H1 is 0.3 µm. FIG. 18 shows a graph of peak values of the density of the p-type impurities in the top body region 24 near the trench insulating film 37 (namely, the channel region 40 of FIG. 1) in a case where IGBTs are manufactured while changing the trench recess depth H1 to various values. In addition, FIG. 19 shows a graph of gate threshold voltages of IGBTs in a case where IGBTs are manufactured while changing the trench recess depth H1 to various values. As shown in FIG. 18, although the slope of the graph is large in the area of the graph where the trench recess depth H1 is smaller than 0.2 µm, the slope of the graph becomes small in the area of the graph where the trench recess depth H1 is 0.2 µm or more. Consequently, in FIG 19 as well, whereas the slope of the graph is about -6.3 V/µm in the area of the graph where the trench recess depth H1 is smaller than 0.2 µm, the slope of the graph is about -0.39 V/µm in the area of the graph where the trench recess depth H1 is 0.2 µm or more. Namely, the slope of the graph changes suddenly bordering around a trench recess depth H1 of 0.2 µm. As has been explained above, if the trench recess depth H1 is 0.2 µm or more, it is unlikely for the variations to occur in the density of p-type impurities of the channel 40 despite the variations in the trench recess depth H 1. Consequently, it is also unlikely for the variations in gate threshold voltage to occur. As has been described above, the trench recess depth H1 in the manufacturing method of the present embodiment is about 0.3 µm. Thus, according to the manufacturing method of the present embodiment, the IGBT 10 can be manufactured while suppressing variations in gate threshold voltage. Furthermore, as shown in FIG. 19, the trench recess depth H1 is more preferably 0.3 µm or more since the slope of the graph becomes roughly constant.

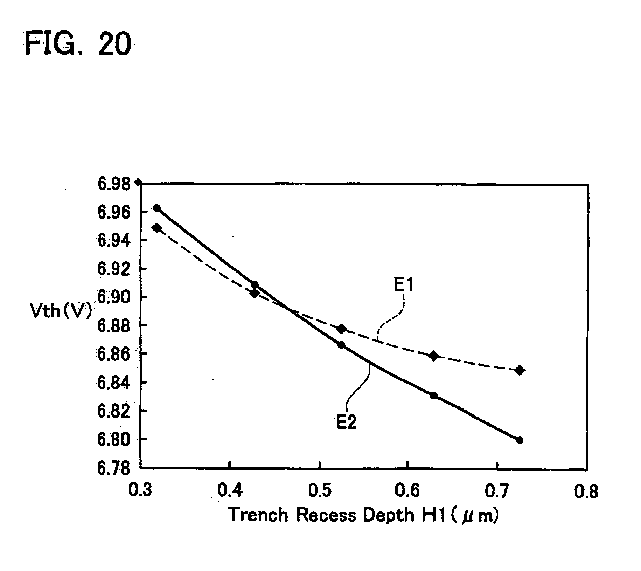

In addition, the variations in the gate threshold voltage as described above also change according to the angle at which ions are injected into the semiconductor substrate 70. If the wall surface of the trench 35 is not parallel to the direction in which the ions are injected, the distribution of the injected impurities differs between the right side of the trench 35 (right side in FIG. 1) and the left side of the trench 35 (left side in FIG. 1). That is, the distribution of the injected impurities is no longer symmetrical. If there is such a difference in the distribution of the impurities between the right side and the left side of the trench 35, this leads to the variation in the gate threshold voltage. Consequently, in the ion injecting direction and the wall surface of the trench 35 are preferably in parallel in the ion injecting steps. On the other hand, when injecting the ions into the semiconductor substrate 70, it is necessary to inject the ions at an angle that does not cause channeling. The amount of the channeling changes according to both of the tilt angle θ1 and an angle θ2 (see FIG. 15, to be referred to as "twist angle θ2") which is an angle between the central axis 82 of the tilt angle θ1 and the 001 crystal orientation of the semiconductor substrate 70. It is typically unlikely for the channeling to occur when the tilt angle θ1 is about 7°. However, the tile angle θ1 is suitably changed as necessary. On the other hand, it is unlikely for the channeling to occur when the twist angle θ2 is 45° or 225°. Note that the central axis 82 is coincident with the 011 crystal orientation in the case where the twist angle θ2 is 45° or 225°. Thus, the ion injecting steps are preferably performed in a positional relationship in which the ion injecting direction and the wall surface of the trench 35 are in parallel and the central axis 82 is coincident with the 011 crystal orientation. In the manufacturing method of the present embodiment, the top surface 70a of the semiconductor substrate 70 is the 100 plane, and the ions are injected in a state where the tilt angle of 7.1° are formed centering around the central axis 82 that is coincident with the 011 crystal orientation. Consequently, the channeling is prevented. In addition, the trench 35 is formed so as to extend perpendicular to the 011 crystal orientation in the top surface 70a of the semiconductor substrate 70 (namely, the 100 plane). Thus, the ion injecting direction 80 and the wall surface of the trench 35 are in parallel. Thus, the impurities are injected at a roughly equal distribution on both sides of the trench 35. As a result, the variations in the gate threshold voltage are further suppressed. A graph E1 of FIG. 20 indicates changes in the gate threshold voltage of IGBTs when the IGBTs are manufactured using a tilt angle θ1 of 7.1°, a twist angle θ2 of 45° and changing the trench recess depth H1 to various values. A graph E2 of FIG. 20 indicates changes in the gate threshold voltage of IGBTs when the IGBTs are manufactured using a tilt angle θ1 of 7.1°, a twist angle θ2 of 135°, and changing the trench recess depth H1 to various values. As shown in FIG. 20, the slope of the graph E1 is smaller than that of the graph E2. Variations in the gate threshold voltage attributable to the trench recess depth H1 can be seen to be able to be further reduced by making the wall surface of the trench 35 parallel with the ion injecting direction 80 and injecting the ions at an angle by which the channeling is unlikely to occur.

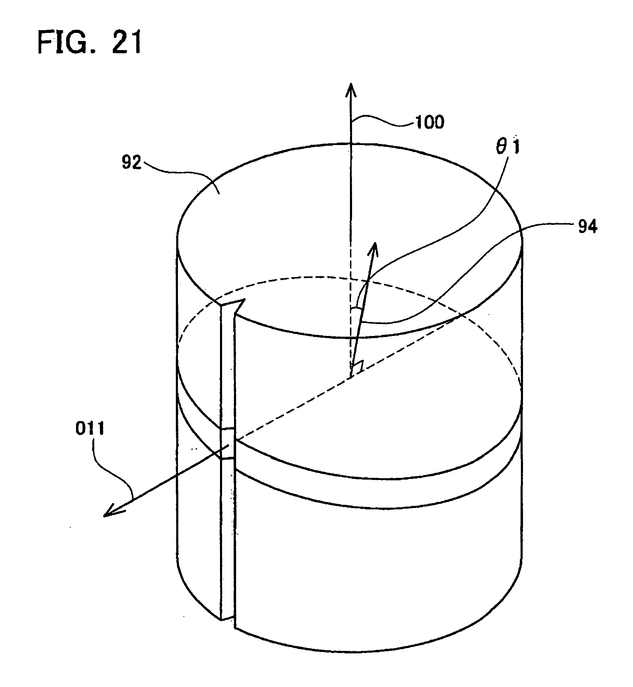

Furthermore, the top surface 70a of the semiconductor substrate 70 is the 100 plane in the embodiment described above. However, the IGBT 10 can also be manufactured in the manner explained below. As shown in FIG. 21, when cutting out a semiconductor substrate from an ingot 92, the semiconductor substrate is cut out by tilting the cutting surface about the 011 crystal orientation by the same degree as the tilt angle θ1 (an arrow 94 in FIG. 21 indicates a direction perpendicular to the top surface (cutting surface) of the semiconductor substrate). The top surface of the semiconductor substrate cut out in this manner is tilted by the angle θ1 about the 011 crystal orientation relative to the 100 plane. The trench 35 is formed in the top surface of this semiconductor substrate so as to extend perpendicular to the 011 crystal orientation. Ion injection is then performed perpendicular to the top surface of the semiconductor substrate. By injecting ions in this manner, the wall surface of the trench 35 and the ion injecting direction are in parallel, and the angle θ1 is formed about the 011 crystal orientation between the ion injecting direction and the 100 crystal orientation. Thus, variations in gate threshold voltage can be reduced in this case as well.

As described above, the production variation of the characteristics of the IGBTs can be suppressed during the mass production of the IGBT using the structure of the IGBT 10 and the manufacturing method of the present embodiment. When this technique is actually performed, the production variation of the on-voltage has been decreased to 1/10 compared to the conventional technique. Also, the production variation of the switching speed has been decreased to 1/10 compared to the conventional technique. Furthermore, the production variation of the gate threshold voltage has been decreased to 1/2 compared to the conventional technique. Furthermore, the production variation of the saturation current has been decreased to 1/2 compared to the conventional technique.

## Claims

1. A method for manufacturing a vertical IGBT(10),
the IGBT (10) comprising:
an emitter region (20) of a first conductive type;
a body region (24, 28) of a second conductive type being adjacent to the emitter region (20) at a deeper side of the emitter region (20);
a drift region (30, 32) of the first conductive type being adjacent to the body region (28) at a deeper side of the body region (28) and being divided from the emitter region (20) by the body region (24, 28);
a collector region (34) of the second conductive type being adjacent to the drift region (32) at a deeper side of the drift region (32) and being divided from the body region (24, 28) by the drift region (30, 32);
a floating region (26) of the first conductive type being formed within the body region (24, 28) and being divided from both of the emitter region (20) and the drift region (30, 32) by the body region (24, 28); and
a gate electrode (36) facing a range of the body region (24, 28) and the floating region (26) via an insulating film (37), the range dividing the emitter region (20) from the drift region (30, 32),
the method comprising:
a trench forming step of forming a trench (35) at a top surface (70a) of a semiconductor substrate (70);
an insulating film forming step of forming the insulating film (37) on an inner wall surface of the trench (35) after the trench forming step by a heat treatment;
a gate electrode forming step of forming the gate electrode (36) in the trench (35) after the insulating film forming step;
a top body region injecting step of injecting second conductive type impurities to the semiconductor substrate (70) after the gate electrode forming step, the second conductive type impurities being injected to a depth corresponding to the body region (24) that is above the floating region (26);
a bottom body region injecting step of injecting the second conductive type impurities to the semiconductor substrate (70) after the gate electrode forming step, the second conductive type impurities being injected to a depth corresponding to the body region (28) that is under the floating region (26); and
a floating region injecting step of injecting first conductive type impurities to the semiconductor substrate (70) after the gate electrode forming step, the first conductive type impurities being injected to a depth corresponding to the floating region (26);
wherein a distance (H1) in a vertical direction between a top surface (36a) of the gate electrode (36) and the top surface (70a) of the semiconductor substrate (70) is ensured by more than or equal to 0.2 µm in the gate electrode forming step.

2. The method of claim 1, wherein
the trench (35) is formed at the top surface (70a) of the semiconductor substrate (70) in the trench forming step so that the trench (35) extends perpendicularly to a 011 crystal orientation of the semiconductor substrate (70), and
in the top body region injecting step, the bottom body region injecting step and the floating region injecting step, the first conductive type impurities and the second conductive type impurities are injected, in a state with an angle (θ1) between an impurities injecting direction (80) and a 100 crystal orientation of the semiconductor substrate (70) about the 011 crystal orientation of the semiconductor substrate (70).

3. The method of any one of claims 1 and 2 wherein the second conductive type impurities are injected in higher density in the top body region injecting step than in the bottom body region injecting step.

## Patentansprüche

1. Verfahren zum Herstellen eines vertikalen IGBTs (10), wobei der IGBT (10) aufweist:
eine Emitterregion (20) eines ersten Leitfähigkeitstyps;
eine Körperregion (24, 28) eines zweiten Leitfähigkeitstyps, der benachbart zu der Emitterregion (20) an einer tieferen Seite der Emitterregion (20) ist;
eine Driftregion (30, 32) des ersten Leitfähigkeitstyps, der benachbart zu der Körperregion (28) an einer tieferen Seite der Körperregion (28) ist, und der von der Emitterregion (20) durch die Körperregion (24, 28) getrennt ist;
eine Kollektorregion (34) des zweiten Leitfähigkeitstyps, der benachbart zu der Driftregion (32) an einer tieferen Seite der Driftregion (32) ist, und von der Körperregion (24, 28) durch die Driftregion (30, 32) getrennt ist;
einen Fließregion (26) des ersten Leitfähigkeitstyps, die in der Körperregion (24, 28) gebildet ist, und sowohl von der Emitterregion (20) als auch von der Driftregion (30, 32) durch die Körperregion (24, 28) getrennt ist; und
eine Gateelektrode (36), die einem Bereich der Körperregion (24, 28) und der Fließregion (26) über eine Isolationsschicht (37) zugewandt ist, wobei der Bereich die Emitterregion (20) von der Driftregion (30, 32) trennt,
wobei das Verfahren aufweist:
einen Grabenbildungsschritt des Bildens eines Grabens (35) an einer oberen Oberfläche (70a) eines Halbleitersubstrats (70);
einen Isolationsschichtbildungsschritt des Bildens der Isolationsschicht (37) auf einer inneren Wandfläche des Grabens (35) nach dem Grabenbildungsschritt durch eine Wärmebehandlung;
einen Gateelektrodenbildungsschritt des Bildens der Gateelektrode (36) in dem Graben (35) nach dem Isolationsschichtbildungsschritt;
einen Obere-Körperregion-Injizierschritt des Injizierens von Verunreinigungen eines zweiten Leitfähigkeitstyps in das Halbleitersubstrat (70) nach dem Gateelektrodenbildungsschritt, wobei die Verunreinigungen des zweiten Leitfähigkeitstyps in eine Tiefe injiziert werden, die der Körperregion (24) entspricht, die oberhalb der Fließregion (26) ist;
einen Untere-Körperregion-Injizierschritt des Injizierens der Verunreinigungen des zweiten Leitfähigkeitstyps in das Halbleitersubstrat (70) nach dem Gateelektrodenbildungsschritt, wobei die Verunreinigungen des zweiten Leitfähigkeitstyps in eine Tiefe injiziert werden, die der Körperregion (28) entspricht, die unter der Fließregion (26) ist; und
einen Fließregioninjizierschritt des Injizierens von Verunreinigungen des ersten Leitfähigkeitstyps in das Halbleitersubstrat (70) nach dem Gateelektrodenbildungsschritt, wobei die Verunreinigungen des ersten Leitfähigkeitstyps in eine Tiefe injiziert werden, die der Fließregion (26) entspricht;
wobei in dem Gateelektrodenbildungsschritt sichergestellt wird, dass ein Abstand (H1) in einer vertikalen Richtung zwischen einer oberen Oberfläche (36a) der Gateelektrode (36) und der oberen Oberfläche (70a) des Halbleitersubstrats (70) größer als oder gleich 0,2 µm ist.

2. Verfahren nach Anspruch 1, wobei
der Graben (35) an der oberen Oberfläche (70a) des Halbleitersubstrats (70) in dem Grabenbildungsschritt gebildet wird, sodass der Graben (35) sich senkrecht zu einer 011-Kristallorientierung des Halbleitersubstrats (70) erstreckt, und
in dem Obere-Körperregion-Injizierschritt, dem Untere-Körperregion-Injizierschritt und dem Fließregioninjizierschritt die Verunreinigungen des ersten Leitfähigkeitstyps und die Verunreinigungen des zweiten Leitfähigkeitstyps in einem Zustand injiziert werden, in dem es einen Winkel (θ1) zwischen einer Verunreinigungsinjizierrichtung (80) und einer 100-Kristallorientierung des Halbleitersubstrats (70) um die 011-Kristallorientierung des Halbleitersubstrats (70) gibt.

3. Verfahren nach einem der Ansprüche 1 und 2, wobei die Verunreinigungen des zweiten Leitfähigkeitstyps mit einer höheren Dichte in dem Obere-Körperregion-Injizierschritt als in dem Untere-Körperregion-Injizierschritt injiziert werden.

## Revendications

1. Procédé de fabrication d'un IGBT vertical (10), l'IGBT (transistor bipolaire à porte isolée) comprenant :
une zone émettrice (20) d'un premier type de conductivité ;
une zone de corps (24, 28) d'un deuxième type de conductivité qui est adjacente à la zone émettrice (20) au niveau d'un côté plus profond de la zone émettrice (20) ;
une zone de migration (30, 32) du premier type de conductivité qui est adjacente à la zone de corps (28) au niveau d'un côté plus profond de la zone de corps (28) et étant séparée de la zone émettrice (20) par la zone de corps (24, 28) ;
une zone de collecteur (34) du deuxième type de conductivité qui est adjacente à la zone de migration (32) au niveau d'un côté plus profond de la zone de migration (32) et étant séparée de la zone de corps (24, 28) par la zone de migration (30, 32) ;
une zone flottante (26) du premier type de conductivité qui est formée à l'intérieur de la zone de corps (24, 28) et étant séparée à la fois de la zone émettrice (20) et de la zone de migration (30, 32) par la zone de corps (24, 28) ; et
une électrode grille (36) faisant face à une plage de la zone de corps (24, 28) et de la zone flottante (26) par l'intermédiaire d'un film isolant (37), la plage séparant la zone émettrice (20) de la zone de migration (30, 32),
le procédé comprenant:
une étape de formation de tranchée qui consiste à former une tranchée (35) au niveau d'une surface supérieure (70a) d'un substrat semi-conducteur (70) ;
une étape de formation de film isolant qui consiste à former le film isolant (37) sur une surface de paroi interne de la tranchée (35) après l'étape de formation de tranchée par un traitement thermique ;
une étape de formation d'électrode grille qui consiste à former l'électrode grille (36) dans la tranchée (35) après l'étape de formation de film isolant (37) ;
une étape d'injection de zone supérieure de corps qui consiste à injecter des impuretés du deuxième type de conductivité au substrat semi-conducteur (70) après l'étape de formation d'électrode grille, les impuretés du deuxième type de conductivité étant injectées à une profondeur correspondant à la zone de corps (24) qui est au dessus de la zone flottante (26) ;
une étape d'injection de zone inférieure de corps qui consiste à injecter les impuretés du deuxième type de conductivité au substrat semi-conducteur (70) après l'étape de formation d'électrode grille, les impuretés du deuxième type de conductivité étant injectées à une profondeur correspondant à la zone de corps (28) qui est au dessous de la zone flottante (26) ; et
une étape d'injection de zone flottante qui consiste à injecter des impuretés du premier type de conductivité au substrat semi-conducteur (70) après l'étape de formation d'électrode grille, les impuretés du premier type de conductivité étant injectées à une profondeur correspondant à la zone flottante (26) ;
dans lequel une distance (Hl) dans une direction verticale entre une surface supérieure (36a) de l'électrode grille (36) et la surface supérieure (70a) du substrat semi-conducteur (70) est assurée par 0,2 µm ou plus dans l'étape de formation d'électrode grille.

2. Procédé selon la revendication 1, dans lequel
la tranchée (35) est formée au niveau de la surface supérieure (70a) du substrat semi-conducteur (70) dans l'étape de formation de tranchée de sorte que la tranchée (35) s'étende perpendiculairement à une orientation cristalline 011 du substrat semi-conducteur (70), et
dans l'étape d'injection de zone supérieure de corps, l'étape d'injection de zone inférieure de corps et l'étape d'injection de zone flottante, les impuretés du premier type de conductivité et les impuretés du deuxième type de conductivité sont injectées, dans un état avec un angle (θ1) entre une direction d'injection d'impuretés (80) et une orientation cristalline 100 du substrat semi-conducteur (70) autour de l'orientation cristalline 011 du substrat semi-conducteur (70).

3. Procédé selon l'une quelconque des revendications 1 et 2, dans lequel les impuretés du deuxième type de conductivité sont injectées avec une densité plus élevée dans l'étape d'injection de zone supérieure de corps que dans l'étape d'injection de zone inférieure de corps.
